Europäisches Patentamt

European Patent Office

Office européen des brevets

(19)

(11) Numéro de publication : **0 080 937**
**B1**

(12) **FASCICULE DE BREVET EUROPÉEN**

(45) Date de publication du fascicule du brevet :
05.03.86

(51) Int. Cl.⁴ : **H 01 L 21/265**, H 01 L 21/225, H 01 L 29/207

(21) Numéro de dépôt : **82402141.4**

(22) Date de dépôt : **24.11.82**

(54) **Procédé de fabrication d'un composant semiconducteur par diffusion avec implantation ionique préalable et composant obtenu.**

(30) Priorité : 26.11.81 FR 8122167

(43) Date de publication de la demande :
08.06.83 Bulletin 83/23

(45) Mention de la délivrance du brevet :
05.03.86 Bulletin 86/10

(84) Etats contractants désignés :
BE DE GB IT NL SE

(56) Documents cités :
US-A- 3 502 518
APPLIED PHYSICS LETTERS, vol. 38, no. 4, février 1981, pages 271-273, New York (USA); P.N. FAVENNEC et al.: "Chromium gettering in GaAs by oxygen implantation"

(73) Titulaire : **Salvi, Michel**
**90, Chemin de la Pointe Ploumanach**
**F-22700 Perros Guirec (FR)**

**Favennec, Pierre Noel**
**Crec'h Lia Beg Leguer**
**F-22300 Lannion (FR)**

**Gauneau, Marcel**
**Rue du Hingar Huellan à Brélévenez**
**F-22300 Lannion (FR)**

(72) Inventeur : **Salvi, Michel**
**90, Chemin de la Pointe Ploumanach**
**F-22700 Perros Guirec (FR)**
Inventeur : **Favennec, Pierre Noel**
**Crec'h Lia Beg Leguer**
**F-22300 Lannion (FR)**
Inventeur : **Gauneau, Marcel**
**Rue du Hingar Huellan à Brélévenez**
**F-22300 Lannion (FR)**

(74) Mandataire : **Mongrédien, André et al**
**c/o BREVATOME 25, rue de Ponthieu**
**F-75008 Paris (FR)**

## Description

La présente invention a pour objet un procédé de fabrication d'un composant semiconducteur par diffusion avec implantation ionique préalable et un composant semiconducteur obtenu par ce procédé. Elle trouve une application en technologie des semiconducteurs, dans la fabrication de dispositifs électroniques ou optoélectroniques utilisant des semiconducteurs composés de type III-V : transistors à effet de champ, transistors bipolaires, circuits intégrés, détecteurs, lasers, diodes électroluminescentes, etc...

Par semiconducteurs composés de type III-V, on entend les semiconducteurs dans la composition desquels entrent des éléments des colonnes III et V de la classification périodique. Par composant on entend tout dispositif comprenant une ou plusieurs couches dopées, ou non.

Les semiconducteurs utilisés dans les dispositifs électroniques ou optoélectroniques comportent en général des couches dopées de types différents (p et n) qui constituent des jonctions. La profondeur d'une jonction est un paramètre important qui détermine les performances du composant. Pour réaliser de telles couches dopées, deux procédés sont en général utilisés : l'implantation ionique et la diffusion thermique.

En général, c'est le procédé de diffusion thermique qui est préféré pour des dopages à profondeur relativement grande avec des métaux de transitions et pour des concentrations élevées. Cependant, ce procédé pose des problèmes de contrôle de la profondeur pour certains couples dopant/semiconducteur (par exemple zinc dans InP). Ces problèmes tiennent à ce que les coefficients de diffusion peuvent être grands, même à basse température, où à ce que des problèmes de diffusion anormale, encore mal compris, provoquent des « queues » de diffusion allant bien au-delà des profondeurs prévues.

Un procédé de fabrication selon le préambule de la revendication 1 est connu du brevet US-A-3 502 518. Ce procédé est appliqué à la réalisation d'une diode p-i-n en arséniure de gallium. L'effet de piégeage du chrome par l'oxygène dans l'arséniure de gallium est également connu de la revue Applied Physics Letters, vol. 38, n° 4, février 1981, pages 271-27.

Le but de la présente invention est précisément de permettre de contrôler la profondeur de diffusion d'une impureté qui est un métal de transition afin d'obtenir une couche dopée qui soit localisée à la surface du substrat et à une profondeur bien déterminée.

Ce but est atteint en provoquant l'arrêt de la diffusion, à la profondeur désirée, par blocage de l'impureté diffusante par une autre impureté qui, elle, est mise en place dans la zone de blocage par implantation ionique.

La nature de l'impureté de blocage est choisie essentiellement de manière qu'elle présente une grande affinité chimique à l'égard du métal de transition constituant l'impureté diffusante. Naturellement, elle doit, en outre, être neutre électriquement dans le matériau où elle est implantée.

Il est alors possible, selon l'invention, de contrôler la profondeur et l'homogénéité de la zone diffusée, par un choix judicieux de la nature et de l'énergie de l'espèce implantée. De plus, il devient possible d'éliminer les queues de diffusion anormale et de supprimer la grande dépendance de la profondeur de diffusion à l'égard du temps et de la température de diffusion.

De façon plus précise, l'invention a pour objet un procédé de fabrication d'un composant semiconducteur dans lequel on dope un substrat semiconducteur composé de type III-V par diffusion thermique d'un métal de transition et selon lequel on effectue, avant cette diffusion, une implantation ionique dans ledit substrat d'une impureté, caractérisé en ce que cette implantation forme une zone enterrée dans laquelle ladite impureté est électriquement neutre et bloque la diffusion dudit métal en raison de son affinité chimique envers celui-ci.

De préférence, l'implantation s'effectue avec une impureté qui appartient au groupe qui comprend l'oxygène, le fluor, le chlore et le brome.

De préférence encore, la dose d'implantation varie entre $10^{13}$ et $10^{15}$ ions/cm$^2$.

La présente invention a également pour objet un composant semiconducteur obtenu par le procédé de la revendication 1 comportant un substrat semiconducteur composé de type III-V comprenant une zone enterrée implantée par une impureté électriquement neutre dans ledit substrat et une région dopée par diffusion thermique d'un métal de transition, caractérisé par le fait que ladite zone enterrée définit la profondeur de la région dopée en raison de l'affinité chimique de ladite impureté envers ledit métal.

De préférence, le métal en question appartient au groupe qui comprend le zinc, le cadmium, le fer.

De préférence encore, la zone implantée est formée d'une impureté qui appartient au groupe qui comprend l'oxygène, le fluor, le chlore et le brome.

Le semiconducteur composé peut être notamment GaAs ou InP.

L'opération de diffusion qui suit l'implantation ionique peut s'effectuer par tout moyen connu.

L'exemple suivant illustre l'invention sans caractère limitatif.

Une implantation de chlore, ou de fluor, ou d'oxygène (impureté bloquante) est effectuée dans un substrat en InP semi-isolant dopé au fer (semiconducteur monocristallin diffusé) à une température de 580 °C et pendant une durée de 20 minutes.

Puis une diffusion de zinc (impureté diffusante) est entreprise.

Pour un substrat non implanté, on obtient une profondeur de diffusion de 5,2 µm et le profil de diffusion comprend une queue de diffusion.

Pour un substrat implanté comme indiqué, la profondeur de la diffusion est réduite à :

1, 2 μm avec le chlore implanté à 1, 6 MeV ;

2, 2 μm avec le fluor implanté à 1, 2 MeV ;

2, 7 μm avec l'oxygène implanté à 1 MeV.

La profondeur de diffusion est donc définie par les conditions d'implantation (nature de l'impureté implantée et énergie). Des couches dopées de très faible épaisseur peuvent être obtenues en abaissant l'énergie d'implantation. De façon générale, cette énergie est comprise entre 0,5 MeV et 2 MeV.

Le procédé qui vient d'être décrit peut s'appliquer à tout dispositif électronique ou optoélectronique exigeant une ou des couches dopées dans des semiconducteurs de type GaAs, InP, ternaires, quaternaires ou autres. Il s'applique également à des structures déjà élaborées et par exemple épitaxiées (homoépitaxie, ou hétéroépitaxie).

Les caractéristiques des composants obtenus par le procédé de l'invention apparaîtront mieux après la description qui suit d'un exemple donné à titre explicatif, en référence aux dessins annexés sur lesquels :

la figure 1 représente en coupe un transistor MISFET (Métal-Isolant-Semiconducteur à Effet de Champ), selon l'art antérieur,

la figure 2 représente, toujours en coupe, un transistor de même type mais obtenu selon le procédé de l'invention.

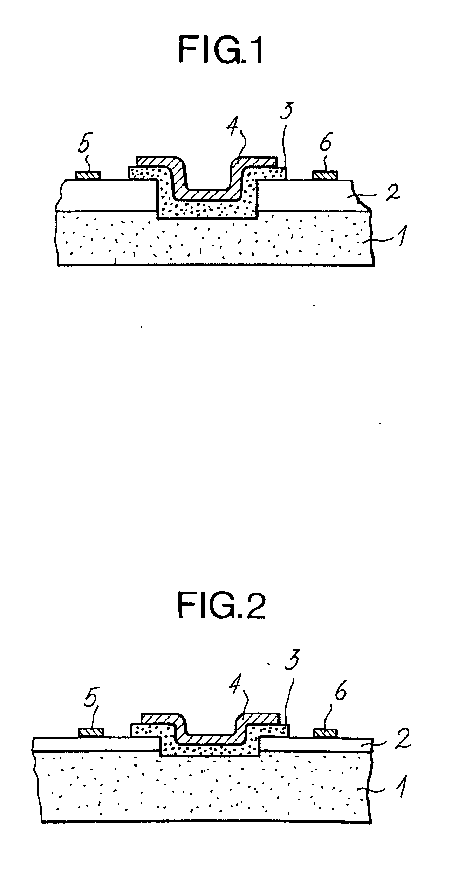

Sur les figures 1 et 2, le transistor représenté est à enrichissement à canal p. Il comprend un substrat 1 en InP semi-isolant dopé au fer, une zone 2 de type $p^-$ diffusée, une couche isolante 3, une métallisation de grille 4, une métallisation de source 5 et une métallisation de drain 6.

Les schémas représentés montrent une grande différence entre les deux cas : sans blocage de l'impureté implantée (figure 1), l'échantillon doit être creusé profondément (jusqu'à plus de 5 μm) pour que soit déposé l'isolant sur le substrat semi-isolant. Dans le cas où selon l'invention le blocage de l'impureté diffusante a été réalisé par une implantation de chlore, l'échantillon est beaucoup moins creusé : une épaisseur de 0,5 μm suffit.

Les différentes étapes du processus de fabrication d'un tel transistor peuvent être les suivantes :

préparation des substrats,

implantation de chlore : 500 keV, $10^{14}$ ions/cm$^2$,

diffusion de Zn, 580 °C, 20 minutes,

dépôt de l'isolant,

dépôt des métallisations de source, grille et drain.

Le processus se poursuit comme dans le cas classique.

## Revendications

1. Procédé de fabrication d'un composant semiconducteur dans lequel on dope un substrat semiconducteur composé de type III-V par diffusion thermique d'un métal de transition et selon lequel on effectue, avant cette diffusion, une implantation ionique dans ledit substrat d'une impureté, caractérisé en ce que cette implantation forme une zone enterrée dans laquelle ladite impureté est électriquement neutre et bloque la diffusion dudit métal en raison de son affinité chimique envers celui-ci.

2. Procédé selon la revendication 1, caractérisé en ce que l'implantation ionique s'effectue avec une énergie comprise entre 0,5 MeV et 2MeV.

3. Procédé selon l'une quelconque des revendications 1 et 2, caractérisé en ce que l'implantation s'effectue avec une impureté qui appartient au groupe qui comprend l'oxygène, le fluor, le chlore et le brome.

4. Procédé selon l'une quelconque des revendications 1 à 3, caractérisé en ce que l'implantation ionique s'effectue avec une dose allant de $10^{13}$ à $10^{15}$ ions/cm$^2$.

5. Composant semiconducteur obtenu par le procédé de la revendication 1 comportant un substrat semiconducteur composé de type III-V comprenant une zone enterrée implantée par une impureté électriquement neutre dans ledit substrat et une région dopée par diffusion thermique d'un métal de transition, caractérisé par le fait que ladite zone enterrée définit la profondeur de la région dopée en raison de l'affinité chimique de ladite impureté envers ledit métal.

6. Composant selon la revendication 5, dans lequel le métal appartient au groupe qui comprend le zinc, le cadmium, le fer.

7. Composant selon l'une quelconque des revendications 5 et 6, caractérisé par le fait que la zone implantée contient une impureté qui appartient au groupe qui comprend l'oxygène, le fluor, le chlore et le brome.

8. Composant selon l'une quelconque des revendications 5 à 7, caractérisé par le fait que le semiconducteur est en GaAs.

9. Composant selon l'une quelconque des revendications 5 à 7, caractérisé par le fait que le semiconducteur est en InP.

## Claims

1. Process for manufacturing a semiconductor device, wherein a semiconductor substrate composed of the type III-V is doped by thermic diffusion of a transition metal, and according to which an ionic implantation of an impurity is effected in said substrate prior to this diffusion, characterised in that this implantation forms a buried zone in which said impurity is electrically neutral and blocks the diffusion of said metal because of its chemical affinity towards the latter.

2. Process according to claim 1, characterised in that the ionic implantation is effected with an energy of between 0,5 MeV and 2 MeV.

3. Process according to any of claims 1 and 2, characterised in that the implantation is effected with an impurity which belongs to the group comprising oxygen, fluorine, chlorine and bromine.

4. Process according to any of claims 1-3, characterised in that the ionic implantation is effected with an amount of from $10^{13}$ to $10^{15}$ ions/cm$^2$.

5. Semiconductor device obtained from the process of claim 1, having a semiconductor substrate composed of the type III-V, comprising a buried zone implanted by an impurity, electrically neutral in said substrate, and an area doped by thermic diffusion of a transition metal, characterised in that said buried zone defines the depth of the area doped because of the chemical affinity of said impurity towards said metal.

6. Device according to claim 5, wherein the metal belongs to the group comprising zinc, cadmium, iron.

7. Device according to any of claims 5 and 6, characterised in that the implanted area contains an impurity which belongs to the group comprising oxygen, fluorine, chlorine and bromine.

8. Device according to any of claims 5-7, characterised in that the semiconductor is in GaAs.

9. Device according to any of claims 5-7, characterised in that the semiconductor is in InP.

**Patentansprüche**

1. Verfahren zur Herstellung einer Halbleiteranordnung, bei dem man ein zusammengesetztes Halbleitersubstrat vom Typ III-V durch thermische Diffusion mit einem Übergangsmetall dotiert und gemäß welchem man vor dieser Diffusion eine ionische Implantation einer Verunreinigung in dem Substrat ausführt, dadurch gekennzeichnet, daß diese Implantation eine vertiefte Zone bildet, in der die genannte Verunreinigung elektrisch neutral ist und die Diffusion des genannten Metalls aufgrund ihrer chemischen Affinität gegenüber jenem blockiert.

2. Verfahren nach Anspruch 1, dadurch gekennzeichnet, daß die ionische Implantation sich mit einer Energie zwischen 0,5 MeV und 2 MeV vollzieht.

3. Verfahren nach einem der Ansprüche 1 und 2, dadurch gekennzeichnet, daß die Implantation sich mit einer Verunreinigung vollzieht, die in der Gruppe erscheint, die Sauerstoff, Fluor, Chlor und Brom enthält.

4. Verfahren nach einem der Ansprüche 1 bis 3, dadurch gekennzeichnet, daß die ionische Implantation sich mit einer Dosis zwischen $10^{13}$ und $10^{15}$ Ionen/cm$^2$ vollzieht.

5. Nach dem Verfahren nach Anspruch 1 hergestellte Halbleiteranordnung, bestehend aus einem halbleitenden Substrat, gebildet vom Typ III-V, enthaltend eine vertiefte Zone, die durch eine elektrisch neutrale Verunreinigung in dem genannten Substrat implantiert ist, und einen durch thermische Diffusion eines Übergangsmetalls dotierten Bereich, gekennzeichnet durch die Tatsache, daß die genannte vertiefte Zone die Tiefe des dotierten Bereiches aufgrund der chemischen Affinität der genannten Verunreinigung gegenüber dem genannten Metall bestimmt.

6. Anordnung nach Anspruch 5, bei der das Metall in der Gruppe erscheint, die Zink, Cadmium, Eisen enthält.

7. Anordnung nach einem der Ansprüche 5 und 6, gekennzeichnet durch die Tatsache, daß die implantierte Zone eine Verunreinigung enthält, die in der Gruppe erscheint, die Sauerstoff, Fluor, Chlor und Brom enthält.

8. Anordnung nach einem der Ansprüche 5 und 7, gekennzeichnet durch die Tatsache, daß der Halbleiter aus GaAs besteht.

9. Anordnung nach einem der Ansprüche 5 und 7, gekennzeichnet durch die Tatsache, daß der Halbleiter aus InP besteht.

# FIG.1

# FIG.2